Europäisches Patentamt

European Patent Office

Office européen des brevets

(11) Numéro de publication: **0 248 705 B1**

(12) **FASCICULE DE BREVET EUROPEEN**

(45) Date de publication de fascicule du brevet:
15.01.92

(21) Numéro de dépôt: **87401161.2**

(22) Date de dépôt: **22.05.87**

(51) Int. Cl.⁵: **G01R 31/28**

(54) Appareil d'irradiation pour circuits électroniques.

(30) Priorité: **27.05.86 FR 8607568**

(43) Date de publication de la demande:
**09.12.87 Bulletin 87/50**

(45) Mention de la délivrance du brevet:
**15.01.92 Bulletin 92/03**

(84) Etats contractants désignés:
**DE GB IT NL**

(56) Documents cités:
**US-A- 4 575 676**

**IEEE TRANSACTIONS ON NUCLEAR SCIEN-CE, vol. NS-28, no. 6, décembre 1981, pages 4022-4025, IEEE, New York, US; J.P. WOODS et al.: "Investigation for single-event upset in MSI devices"**

**NUCLEAR INSTRUMENTS AND METHODS, vol. 191, no. 1-3, 1981, pages 437-442, North-Holland Publishing Co., Amsterdam, NL; A.B. CAMPBELL et al.: "Investigation of soft upsets in MOS memories with a microbeam"**

(73) Titulaire: **COMMISSARIAT A L'ENERGIE ATO-MIOUE Etablissement de Caractère Scientifique Technique et Industriel**
**31/33, rue de la Fédération**
**F-75015 Paris(FR)**

(72) Inventeur: **Musseau, Olivier**
**Rési. La Voie du Sud-B1**
**F-91160 Longjumeau(FR)**
Inventeur: **Deschazeaux, Gérard**
**51, rue Trouchard**
**F-91800 Brunoy(FR)**

(74) Mandataire: **Mongrédien, André et al**
**c/o BREVATOME 25, rue de Ponthieu**
**F-75008 Paris(FR)**

Rank Xerox (UK) Business Services

## Description

La présente invention consiste en un appareil simulateur d'ambiances radioactives destiné à étudier le comportement des circuits électroniques soumis à une irradiation. Ce problème concerne plus précisément les circuits électroniques embarqués dans des navettes spatiales et des satellites soumis aux rayonnements cosmiques. L'irradiation de ces circuits peut entraîner deux conséquences dommageables : le basculement des bits du niveau logique 0 au niveau logique 1 ou vice-versa, et la création de courts-circuits susceptibles d'entraîner à court terme la dégradation des circuits électroniques concernés. Il s'est donc avéré nécessaire d'essayer ces circuits avant leur utilisation effective dans l'espace, et on a déjà imaginé des appareils permettant de satisfaire à cette exigence.

Un premier groupe de ces appareils consiste à utiliser un accélérateur de particules et à dévier une partie du faisceau sur le circuit électronique. Toutefois, l'emploi de tels appareils est compliqué et lourd et on a donc construit des irradiateurs spécialement adaptés à cette utilisation. Ils se composent essentiellement d'une enceinte à vide dans laquelle on enferme le circuit à tester, un dosimètre pour caractériser le rayonnement, et une source radioactive. L'un d'entre eux est le sujet du brevet américain nᵒ4 575 676 au nom de Palkuti. La source de rayonnement est un tube à rayons X, et il comprend en outre des dispositifs logiques de sécurité qui interrompent l'émission de rayons X si un volet obturateur et l'enceinte à vide sont simultanément ouverts. Cet irradiateur nécessite l'emploi d'un micro-ordinateur à cette fin. Il présente par ailleurs l'inconvénient de ne pas garantir des conditions d'irradiation du circuit identiques à celles mesurées par le dosimètre, car aucun moyen de positionnement ou de réglage précis n'est mentionné.

La présente invention a pour objet d'éviter ces inconvénients et de fournir un appareil irradiateur de circuits électroniques dont les commandes sont simples et toutes situées hors de l'enceinte à vide dont les conditions d'irradiation sont indéréglables au cours de l'essai et semblables aux conditions d'étalonnage par le dosimètre, et qui possède des dispositifs de sécurité de nature principalement mécanique qui présentent l'avantage d'être très fiables et qui empêchent toute possibilité d'irradiation d'un opérateur non conscient des risques encourus.

La présente invention a donc pour objet un appareil d'irradiation pour circuits électroniques comprenant une enceinte à vide démontable en au moins deux parties et étanche aux radiations, un moyen de réaliser le vide à l'intérieur de cette enceinte, un chariot mobile porteur d'une source radioactive et un plateau ascensionnel de mise en position du circuit électronique à tester, muni en outre d'un détecteur de rayonnement, comprenant en outre des commandes de déplacement du circuit électronique et du détecteur liées à une des parties de l'enceinte à vide et manipulées de l'extérieur de ladite enceinte, caractérisé en ce qu'il comprend en outre une commande de déplacement de la source liée à une des parties de l'enceinte à vide et manipulée de l'extérieur de ladite enceinte, de manière à amener tour à tour la source dans une première position non irradiante, dans une deuxième position irradiant le détecteur, dans une troisième position irradiant le circuit électronique, ainsi qu'un moyen de repérage de la présence de la source dans chacune de ces trois positions.

Selon une caractéristique importante de l'invention, cet appareil d'irradiation comporte en effet un couvercle lié à l'enceinte à vide qui empêche la source d'émettre un rayonnement pour une certaine position de cette source. Il comprend également un moyen qui empêche l'irradiation quand l'enceinte n'est pas assemblée, et un moyen qui empêche le démontage de l'enceinte quand la source émet un rayonnement. Ces moyens sont essentiellement composés d'un électro-aimant mobile et muni de deux verrous pointant dans des directions opposées, destinés à bloquer respectivement l'enceinte à vide en position assemblée et un dispositif de maintien de la commande de la source en position non irradiante. Ce dispositif comprend une bielle fixée par une extrémité au socle de l'appareil, munie d'une tige apte à recevoir le verrou correspondant à son autre extrémité, l'articulation de la bielle et de la tige étant utilisée comme moyen de blocage de la commande.

Selon une caractéristique avantageuse de l'appareil, il comprend encore un dispositif permettant de rendre inactives les commandes de déplacement en translation du circuit et du détecteur de rayonnement quand la source émet un rayonnement.

L'invention sera cependant mieux comprise par la description accompagnant les figures dont l'énumération suit, figures données à titre illustratif et non limitatif :
- la figure 1 représente une vue de face en coupe diamétrale de l'invention ;
- la figure 2 représente une vue de dessus de l'invention selon la ligne de coupe II-II ;
- la figure 3 représente une vue de dessus du dispositif porteur de la source radioactive et des pièces voisines ;
- la figure 4 représente une vue de côté du dispositif de verrouillage de la source radioactive en position non irradiante ; et
- la figure 5 représente le tableau qui indique l'état du système et la séquence d'opérations à effectuer.

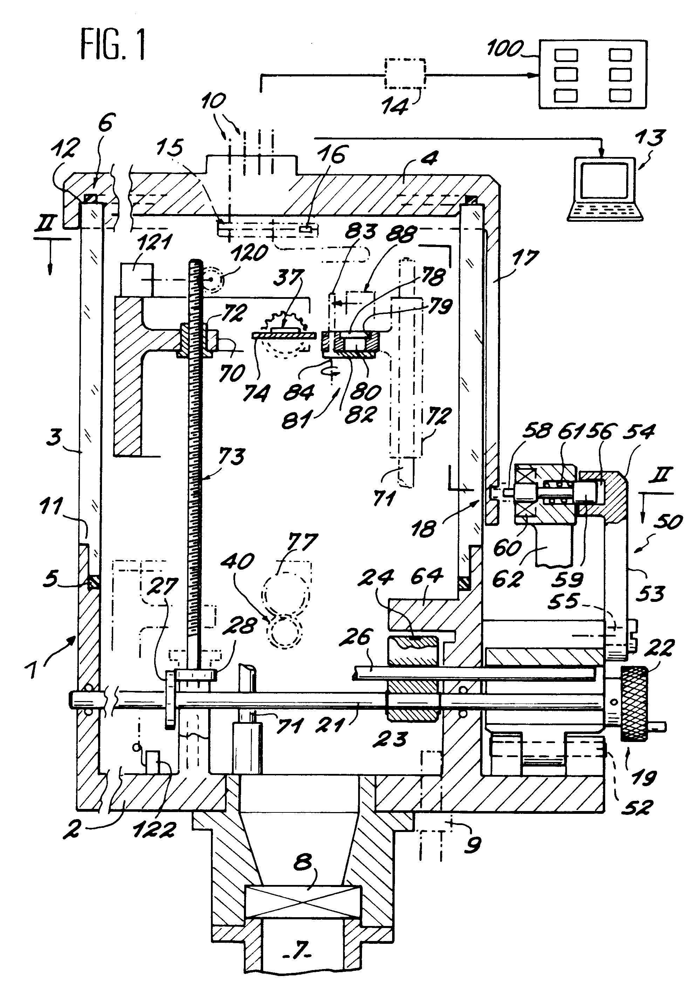

Si on se réfère à la figure 1, on constate donc que l'invention comprend tout d'abord une enceinte à vide 1 de forme généralement cylindrique qui se compose d'un socle 2, d'une cloche de verre 3 et d'un couvercle 4 ; des joints d'étanchéité toriques permettent d'assurer le vide : on trouve le joint 5 entre le socle 2 et la cloche 3 et le joint 6 entre la cloche 3 et le couvercle 4. Le socle 2 comprend un moyen de pompage 7 composé classiquement d'un tuyau et d'une pompe. Il comprend en outre un filtre 8 qui permet d'éviter d'entraîner les particules radioactives avec le gaz aspiré en cas d'écaillage de la source radioactive. Le socle 2 comprend également un capteur de pression 9.

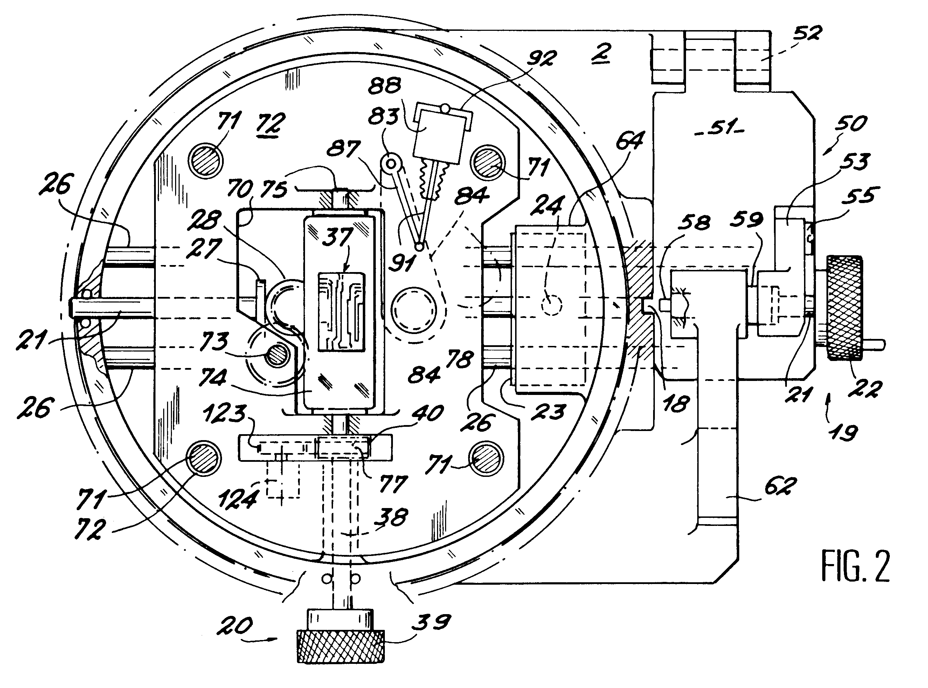

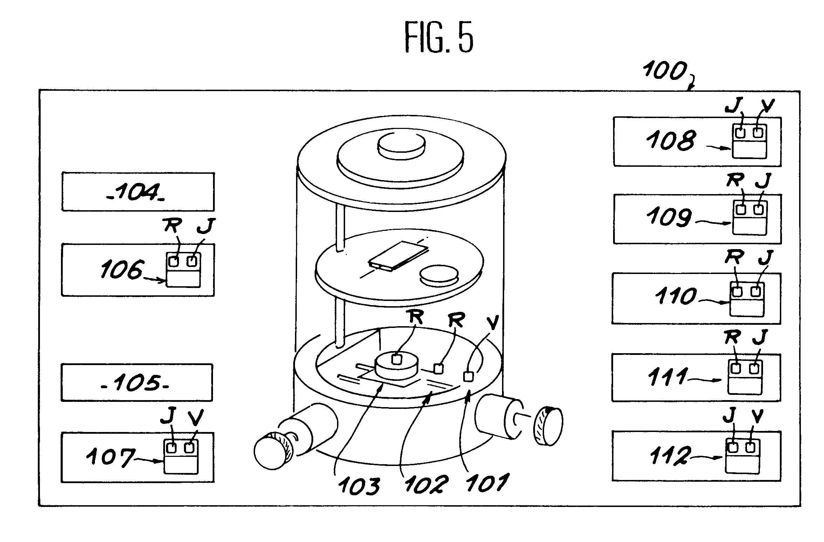

Le couvercle 4 comprend quant à lui des moyens d'alimentation électrique 10 dont le but consiste à la fois à relier les broches des circuits électroniques à tester à un système électrique 13 qui permet d'effectuer la vérification de ce circuit électronique, par exemple au moyen d'un micro-ordinateur, et à relier divers contacts électriques à un réseau de logique câblée 14 non représenté en détail ici, et dont l'objectif consiste à la fois à fournir des informations au tableau 100 représenté plus en détail figure 5 et à exercer certaines fonctions de commande du dispositif qui sont expliquées ci-dessous. Deux de ces contacts électriques sont le contact 11 qui définit la fermeture de la cloche 3 sur le socle 2 et le contact 12 qui définit la fermeture du couvercle 4 sur la cloche 3. Il existe encore un contact 16 qui assure que le raccordement des câbles 10 a bien été effectué au moment de l'assemblage du couvercle 4 par assemblage d'un connecteur 15. Le couvercle 4 est muni d'une patte 17 qui descend le long de la cloche de verre 3 qui est munie d'un perçage 18 à son extrémité inférieure. On trouve encore sur l'appareil une commande de translation 19 et une commande de rotation 20 représentées figure 2.

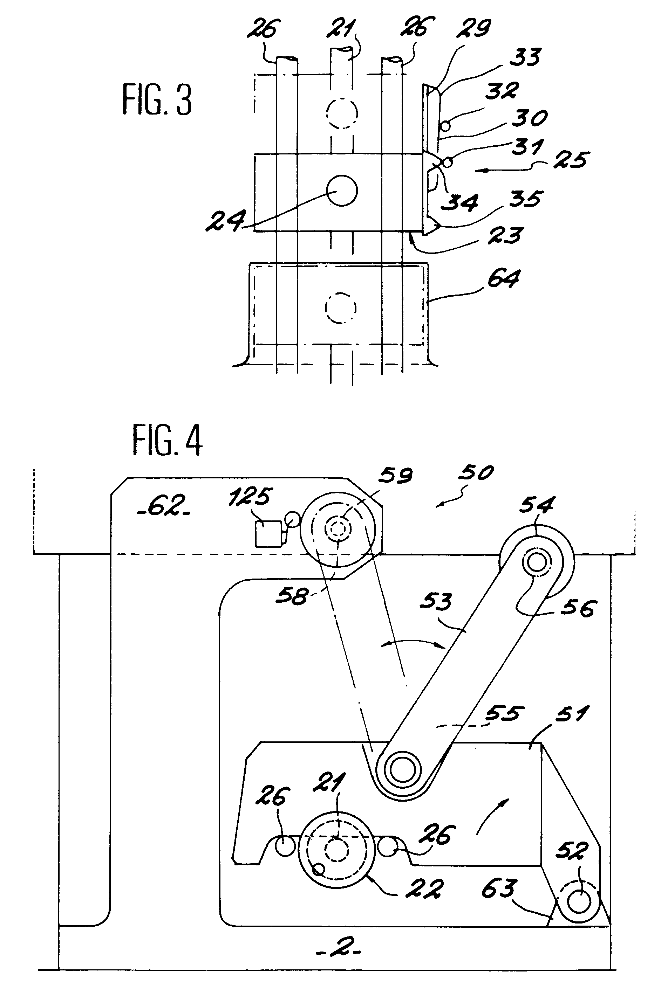

La commande de translation 19 se compose essentiellement d'une tige 21 prolongée à son extrémité par une poignée 22. Sur cette tige 21 est disposé un chariot 23 situé à l'intérieur de l'enceinte à vide 1 sur lequel se trouve la source radioactive 24 qui se présente dans la pratique sous forme d'une pastille. A l'intérieur de l'enceinte à vide 1 et également disposée sur la tige 21 se trouve une roue 27 qui, en liaison avec un pignon 28, autorise un renvoi d'angle à 90°. Comme il apparaît plus nettement d'après la figure 3, le chariot 23 coulisse le long de deux glissières 26 et possède en outre sur son côté une came double 25 composée d'une came supérieure 29 et d'une came inférieure 30. Selon la position du chariot 23, ces cames peuvent assurer la fermeture de contacts électriques 31 et 32 respectivement. A cet effet, la came inférieure 30 est munie d'un bossage 33 qui permet de repérer l'irradiation de l'intérieur de l'enceinte à vide 1, alors que la came supérieure 29 comprend deux bossages, dont le premier d'entre eux 34 permet d'indiquer que la source radioactive 24 est disposée au-dessous du détecteur de rayonnement 78 ; le second bossage 35 de cette came supérieure 29 sert à indiquer que la source radioactive 24 est disposée au-dessous du circuit électronique 37 à tester.

La commande de rotation 20 comprend une tige 38, commandée en rotation par une manivelle 39 disposée à l'extérieur de l'enceinte à vide 1 ; à l'extrémité de cette tige 38 disposée à l'intérieur de l'enceinte à vide 1 se trouve une roue dentée 40.

Selon une caractéristique importante de l'invention, à la commande de translation 19 est associé un dispositif de blocage 50 représenté plus en détail figure 4 constitué d'une bielle 51 tournant autour d'un axe 52 situé sur une structure porteuse 63 liée au socle 2, d'une barre de verrouillage 53 qui s'articule par une extrémité à la bielle 51 selon une articulation 55 et qui est munie d'une douille 54 percée d'un évidement 56 à son autre extrémité ; ce dispositif de blocage 50 comprend également, monté sur une structure de maintien 62 liée au socle 2, un ensemble constitué d'un électro-aimant 60 et de deux verrous pointant dans des directions opposées ; l'un de ces verrous 59 bloque la bielle 51 et la barre de verrouillage 53 en s'insérant dans l'évidement 56 de celle-ci, alors que l'autre verrou 58 se trouve en regard du perçage 18 de la patte 17 du couvercle 4 et est susceptible de s'insérer dans celui-ci par suite du déplacement de l'électro-aimant 60 consécutif à non excitation. Cette configuration est décrite en traits mixtes sur la figure 1. On constate alors que le verrou 59 ne bloque plus la barre de verrouillage 53, ce qui la rend mobile ainsi que la bielle 51.

Le ressort 61 travaille en traction et permet donc le retour et le maintien de l'électro-aimant 60 sur la paroi de la structure de soutien 62 quand l'électro-aimant n'est pas excité.

A l'intérieur de l'enceinte à vide 1 se trouve un plateau ascensionnel 70 de support du circuit électronique 37 et d'un détecteur de rayonnement 78. Le plateau 70 est susceptible de se déplacer verticalement le long de colonnes 71 auxquelles il est lié par des bagues 72. Une de ces colonnes est constituée d'une vis sans fin 73 dont la rotation, commandée par la roue 27 et le pignon 28, assure le déplacement du plateau 70. La bague 72 associée à la vis sans fin 73 est évidemment filetée de façon adaptée le long de sa surface intérieure.

Le circuit électronique 37 est placé sur un porte-circuits adapté assurant les connexions électriques. Ce support 74 est inclinable autour d'un axe 75 relié à une roue dentée 77 susceptible d'être engrenée avec la roue dentée 40 comme il apparaît sur la figure 2.

Selon une réalisation avantageuse de l'invention, le centre du circuit électronique 37 est placé sur l'axe 75 de façon à ce que sa rotation ne change pas sa distance globale vis-à-vis de la source radioactive 24.

Le détecteur de rayonnement 78 est disposé de préférence dans un évidement de logement 79 fraisé dans le plateau 70. Une lumière 80 est apportée au-dessous de la surface de mesure de ce détecteur, qui peut être cachée par la surface 82 d'un obturateur 81 dont le manche 83 passe par un passage 84 alésé dans le plateau 70. Un ressort en spirale non représenté ici tend à maintenir l'obturateur 81 dans la position indiquée sur la figure 1, c'est-à-dire de façon à aveugler le détecteur 78. Son ouverture peut être commandée par un électro-aimant 88 dont l'excitation entraîne la traction d'une lamelle 91 qui lui est reliée et qui tend alors à faire tourner l'obturateur 81 par l'intermédiaire d'un téton 87 fixé sur son manche 83. L'électro-aimant est disposé sur une structure de maintien 92 fixée au plateau 70 et qui peut en outre, selon une réalisation avantageuse de l'invention, se recourber en capot protecteur dans sa partie supérieure.

Le tableau 100, qui est représenté plus en détail figure 5, est relié au réseau de logique câblée 14. Il comprend divers témoins lumineux rouges, jaunes et verts notés respectivement R, J et V sur la figure 5. Trois de ces témoins sont isolés sur le tableau 100 : les témoins 101 vert, 102 rouge et 103 rouge qui repèrent trois positions particulières de la source radioactive 24 : non irradiante, sous le détecteur 78, sous le circuit 37. Ils peuvent être disposés de façon suggestive sur une schématisation de l'appareil comme on le représente ici. Les autres témoins lumineux sont associés par groupes de deux sur des boutons-poussoirs : trois d'entre eux 107, 108 et 112 sont munis d'un témoin jaune et d'un témoin vert et sont associés respectivement à la rotation du circuit 37, au connecteur 15 et à la translation du circuit 37. Les quatre autres 106, 109, 110, 111 sont munis d'un voyant rouge et d'un voyant jaune et sont associés respectivement à l'irradiation du circuit 37, au détecteur 78, à la mise en service de ce détecteur et à la translation de la source radioactive 24.

Le tableau de commande 100 comprend en outre deux affichages digitaux 104 et 105 qui indiquent l'angle d'inclinaison du circuit 37 et la projection verticale de sa distance à la source 24. Si l'on excepte les trois témoins isolés 101, 102, 103, les témoins verts allumés indiquent généralement qu'une opération est immédiatement possible sans risque d'irradiation, les témoins rouges allumés signifient qu'une opération sous irradiation est effectuée et les témoins jaunes allumés expriment que l'opération correspondante est possible ou doît être effectuée pour arriver à un état souhaité par l'utilisateur. Dans le premier cas, on utilise le tableau 100 en mode descriptif et les voyants sont utilisés pour indiquer l'état du système à tout moment. Dans le deuxième cas, l'utilisateur travaille en mode instructif et appuie sur le bouton-poussoir 106 à 112 correspondant à l'opération qu'il souhaite effectuer ; le tableau 100 lui indique alors les manoeuvres à effectuer successivement par allumage en séquence des témoins jaunes correspondant à ces manoeuvres. On est donc en présence d'un véritable système interactif qui constitue une des originalités de l'invention. Les moyens logiques de réaliser ces fonctions interactives, schématisés figure 1 par le réseau de logique câblée 14, sont cependant faciles à réaliser pour quiconque est versé dans la technique correspondante et ne seront pas détaillés ici. On donnera un exemple d'utilisation de ce mode instructif après avoir décrit plus en détail la réalisation d'un essai d'irradiation et les répercussions des opérations réalisées tour à tour sur le tableau 100, qui est donc supposé travailler en mode descriptif.

La première tâche consiste à disposer le circuit électronique 37 à tester sur le plateau ascensionnel 70 et à brancher ses broches sur les câbles de connexion 10. Dans une réalisation de l'invention, le nombre de câbles disponibles à cet effet est de quarante, mais on peut envisager des adaptations qui comprendraient un nombre de câbles disponibles plus important sans affecter les principes de l'invention.

On monte ensuite l'enceinte à vide 1 en positionnant la cloche 3 sur le socle 2, puis le couvercle 4 sur la cloche 3 après avoir branché les câbles de connexion 10 au connecteur 15 : les broches du circuit 37 sont alors reliées à la machine de vérification 13 ; d'autre part, les contacts électriques 31 et 32 sont reliés au réseau de logique câblée 14 et donc en état d'être utilisés. La configuration des pièces mécaniques est alors la suivante : la source radioactive 24 est bloquée contre la paroi intérieure de l'enceinte à vide 1 et recouverte d'un couvercle 64 qui arrête le rayonnement de cette source 24, qui est en position dite "rangée". Elle peut toutefois être sortie car l'électro-aimant a été excité par la fermeture simultanée des contacts 11 entre le socle 2 et la cloche 3 et 12 entre la cloche 3 et le couvercle 4, ainsi que par celle du contact 16 qui exprime que les câbles de connexion 10 ont été reliés au connecteur 15. C'est alors le verrou 58 qui est en service et qui empêche le démontage du couvercle 4 en s'insérant dans le perçage 18.

Le couvercle 64, de même que l'obturateur 81, doit être suffisamment épais pour jouer son rôle de protection. Dans le cas de simulation de rayonnement cosmique, la radioactivé à reproduire est relativement faible et une épaisseur de 2 mm d'acier convient pour les pastilles de californium 252 disponibles sur le marché.

A ce moment, les témoins suivants sont allumés :

- le témoin vert 108 qui assure que les connexions électriques sont effectuées et que la source 24 est rangée ;
- le témoin vert 101 qui indique que la source 24 est rangée, et le témoin jaune 111 ;
- le témoin vert 112 qui indique que la translation verticale du plateau 70 est possible.

On réalise donc la descente de ce plateau 70 en tournant la poignée 22 qui entraîne la roue 27 et le pignon 28 qui sont en contact pour cette position précise de la source 24. La vis sans fin 73 assure la descente du plateau 70, ainsi que la rotation d'une roue dentée 120 liée à un potentiomètre 121 qui exprime la hauteur du circuit 37 par rapport à la source 24 sur l'affichage digital 104.

Quand le plateau 70 est en position basse, le témoin vert 107 s'allume par déclenchement d'un contact 122 et indique que la rotation du circuit 37 est possible : en effet, dans cette position, les roues dentées 40 et 77 s'engrènent et la commande de rotation 20 du circuit 37 peut être utilisée. La roue dentée 77 est par ailleurs liée à une autre roue dentée 123 solidaire d'un potentiomètre 124 dont l'état est traduit par l'affichage digital 105 d'angle d'inclinaison du circuit 37.

Après avoir effectué le réglage de l'angle d'inclinaison, il est possible de remonter le plateau 70 à la hauteur voulue pour simuler correctement le niveau d'irradiation souhaité. Le témoin vert 107 associé à la rotation du circuit s'éteint.

L'étape suivante consiste à sortir la source radioactive 24. Pour cela, on bascule la barre de verrouillage 53 le long de la bielle 51, puis on fait pivoter celle-ci autour de son axe 52. La commande de translation 19 est alors libérée et la poignée 22 peut être poussée. Le contact de la roue 27 et du pignon 28 n'existe plus, si bien que le déplacement du circuit est désormais impossible : le déréglage des conditions d'essai est empêché.

Dès la sortie de la source radioactive 24, le bossage 33 de la came inférieure 30 ferme un contact 32 qui éteint les témoins verts 101, 108 et 112, remplace le témoin jaune 111 par le témoin rouge et allume les témoins rouges 102 et 103 qui expriment que la source 24 est sortie et rayonne. Cette situation dure jusqu'à ce que le bossage 34 de la came supérieure 29 ferme le contact 31 : alors, le témoin rouge 103 s'éteint et le témoin rouge 109 s'allume, ce qui traduit le fait que la source radioactive 24 se trouve juste au-dessous du détecteur 78, donc en état d'irradier correctement celui-ci, et que l'obturateur 81 peut être ôté, ce qui s'effectue en poussant le bouton 110 dont le témoin rouge s'allume alors.

Quand on estime que l'irradiation du détecteur 78 a été suffisante pour étalonner la source 24, on referme l'obturateur 81 par une nouvelle poussée du bouton 110 et on pousse de nouveau la source 24 à l'aide de la poignée 22. Le contact 31 s'ouvre et le tableau 110 présente le même aspect qu'avant le passage du contact 31 sur le bossage 34. Cette situation dure jusqu'à ce que le contact 31 soit fermé par le bossage 35 : à ce même moment, la came inférieure 30 s'interrompt et le contact correspondant 32 s'ouvre : la source radioactive 24 se trouve juste au-dessous du circuit électronique 37 à irradier ; le tableau 100 présente alors les témoins rouges 103, 106 et 111 allumés, qui indiquent que le circuit est irradié dans les conditions prévues et que la source radioactive 24 est bien sortie ; la redondance de l'information se justifie pour des raisons de sécurité.

On abandonne le système dans cet état le temps nécessaire pour effectuer la simulation souhaitée, après quoi on replie la source 24 jusqu'à sa position rangée, sous le couvercle 64 : le tableau de commandes 100 présente alors les témoins verts 101, 108 et 112 allumés ; ils indiquent respectivement que la source 24 est rangée, que la source 24 est rangée et que les câbles de connexion 10 sont correctement branchés et que le déplacement vertical du plateau 70 est de nouveau possible.

Si on désire procéder au démontage du système, on procède en déployant la bielle 51 et la tige de verrouillage 53 : quand l'articulation 55 bloque la commande de translation 20 et que l'évidement 56 est en face du verrou 59, un contact 125 se ferme et entraîne la mise au repos de l'électroaimant 60 que le ressort 61 ramène en butée sur la paroi de la structure de soutien 62. Le verrou 59 entre dans l'évidement 56, en revanche le verrou 58 libère le trou 18 ; à ce moment, l'enceinte à vide pet être démontée, sans danger puisque la source 25 est rangée, ce que signalent respectivement les témoins allumés jaune 108 et vert 101.

Bien entendu, il faut égaliser les pressions. On emploie de préférence un circuit d'azote non représenté ici, qui crée un milieu gazeux plus propre que l'air ambiant. Le démontage de l'enceinte 1 peut alors être effectué.

Si à présent l'utilisateur ignore l'ordre nécessaire des opérations pour arriver à un état déterminé du système, il peut utiliser le tableau 100 en mode instructif. C'est en partie dans ce but que les boutons poussoirs 106 à 112 existent et sont munis de témoins jaunes.

Exemple 1

A partir du montage de l'enceinte à vide 1, l'utilisateur désire arriver à l'irradiation du circuit 37. Il appuie donc sur le bouton correspondant 106 et le témoin jaune 111 lui indique qu'il peut sortir la source. Il effectue ce déplacement jusqu'à ce que la source radioactive 24 se trouve en-dessous du circuit 37, alors le témoin jaune s'éteint et est remplacé par le témoin jaune 106 qui indique que le changement d'état souhaité est intervenu.

Exemple 2

A partir de cet état d'irradiation du circuit 37, l'utilisateur désire effectuer une mesure d'irradiation au moyen du détecteur 78. Il appuie sur le bouton 110 ; le témoin jaune 111 s'allume et lui indique qu'il faut déplacer la source 24. Quand celle-ci est juste au-dessous du détecteur 78, ce témoin s'éteint et le témoin jaune 110 s'allume, indiquant que l'obturateur 81 peut être ouvert.

Exemple 3

A partir de l'irradiation du circuit 37, l'utilisateur désire à présent corriger l'angle d'inclinaison de ce circuit. Il appuie donc sur le bouton 107. Le témoin jaune 111 s'allume et lui indique qu'il faut déplacer la source 24. Quand celle-ci est rangée, ce témoin est remplacé par le témoin jaune 112 qui montre que le plateau 70 doit être abaissé jusqu'à être en position basse ; quand cette condition est réalisée, les roues dentées 40 et 77 sont en contact et la rotation du circuit 37 est possible ; c'est alors le témoin jaune 107 correspondant à la fonction souhaitée qui est allumé.

Exemple 4

A partir de cet état, on désire démonter le système. On appuie sur le bouton 108. Le témoin jaune 111 s'allume et reste allumé jusqu'à ce que la source soit rangée et la commande de translation 20 bloquée au moyen du verrou 59 comme on l'a décrit ci-dessus ; le témoin jaune 108 s'allume alors et signale que l'on peut procéder au démontage de l'enceinte à vide 1.

Pour ces différents exemples, les voyants rouges et verts s'allument comme il a été décrit plus haut ; leurs conditions d'emploi ne sont pas affectées.

L'appareil simulateur d'irradiation qui a été décrit ci-dessus apporte donc plusieurs avantages par rapport aux appareils de même famille que l'on trouve déjà sur le marché : le réglage de la position du circuit électronique 37 à tester et de la source radioactive 24 est simplifié par le fait que l'on ne dispose que d'une translation verticale (et d'une rotation le cas échéant) pour le premier, d'une translation horizontale pour la seconde ; le détecteur de rayonnement 78 est forcément irradié dans les mêmes conditions que le circuit électronique 37 dont il est solidaire ; de plus, la conception mécanique qui a été choisie assure que les opérations d'obtention d'un essai se déroulent suivant un ordre bien défini, qui limite les risques d'erreur et surtout assure une protection radiologique totale ; enfin, le tableau est apte à venir constamment en aide à l'opérateur par son fonctionnement descriptif de l'état du système et son fonctionnement instructif, qui constitue un véritable guide des opérations à effectuer.

Cet appareil est conçu avant tout pour le test de circuits électroniques soumis à un rayonnement cosmique. Toutefois, on peut envisager son extension à la reproduction de rayonnements possédant un spectre de répartition d'énergie différent. Il suffit pour cela de posséder la source radioactive appropriée. En outre, les spectres de rayonnements émis peuvent être considérablement modifiés si on maintient une pression résiduelle dans l'enceinte, et c'est encore un paramètre sur lequel on peut jouer.

L'appareil n'est donc nullement limité à l'irradiation par californium 252, même si cet élément radioactif est le plus couramment utilisé pour la simulation de rayonnement cosmique.

**Revendications**

1.  Appareil d'irradiation pour circuits électroniques comprenant une enceinte à vide (1) démontable en au moins deux parties et étanche aux radiations, un moyen (7) de réaliser le vide à l'intérieur de cette enceinte (1), un chariot (23) mobile porteur d'une source radioactive (24) et un plateau ascensionnel (70) de mise en position du circuit électronique (37) à tester, muni en outre d'un détecteur de rayonnement (78), comprenant en outre des commandes (19, 20) de déplacement du circuit électronique (37) et du détecteur (78) liées à une des parties (2) de l'enceinte à vide (1) et manipulées de l'extérieur de ladite enceinte (1), caractérisé en ce qu'il comprend en outre une commande de déplacement de la source (24) liée à une des parties (2) de l'enceinte à vide (1) et manipulée de l'extérieur de ladite enceinte (1), de manière à amener tour à tour la source (24) dans une première position non irradiante, dans une deuxième position irradiant le détecteur (78), dans une troisième position irradiant le circuit électronique (37), ainsi qu'un moyen de repérage (29, 30, 101, 102, 103) de la présence de la source (24) dans chacune de ces trois positions.

2. Appareil d'irradiation selon la revendication 1, caractérisé en ce qu'il comprend une source radioactive (24) se désintégrant par fission spontanée.

3. Appareil d'irradiation selon la revendication 2, caractérisé par le fait que la source radioactive (24) est composée de californium 252.

4. Appareil d'irradiation selon l'une quelconque des revendications 1 à 3, caractérisé en ce qu'il comprend un couvercle (64) lié à l'enceinte à vide (1) qui empêche la source (24) d'émettre un rayonnement pour une certaine position de cette source (24).

5. Appareil d'irradiation selon l'une quelconque des revendications 1 à 4, caractérisé en ce qu'il comprend un moyen de blocage mécanique (50) qui empêche l'irradiation quand l'enceinte (1) n'est pas assemblée.

6. Appareil d'irradiation selon l'une quelconque des revendications 1 à 5, caractérisé en ce qu'il comprend un moyen (50) qui empêche le démontage de l'enceinte (1) quand la source (24) émet un rayonnement.

7. Appareil simulateur d'irradiation selon les revendications 5 et 6, caractérisé en ce qu'il comprend un électro-aimant (60) mobile et muni de deux verrous (58, 59) pointant dans des directions opposées, destinés à bloquer respectivement l'enceinte (1) en position assemblée, et un dispositif (51, 53, 55) de maintien de la commande (19) de la source (24) en position non irradiante.

8. Appareil d'irradiation selon la revendication 7, caractérisé en ce que le dispositif (51, 53, 55) comprend une bielle (51) fixée par une extrémité au socle (2) de l'appareil, munie d'une tige (53) apte à recevoir le verrou (59) à son autre extrémité, l'articulation (55) de la bielle (51) et de la tige (53) étant utilisée comme moyen de blocage de la commande (19).

9. Appareil d'irradiation selon la revendication 1, caractérisé en ce qu'il comprend un moyen d'obturation (81) du détecteur de rayonnement (78) quand la source (24) n'est pas placée de façon à irradier correctement celui-ci.

10. Appareil d'irradiation selon l'une quelconque des revendications 1 à 8, caractérisé en ce qu'il comprend un dispositif (27, 28) permettant de rendre inactive la commande (19) de déplacement en translation du circuit (37) et du détecteur de rayonnement (78) quand la source (24) émet un rayonnement.

11. Appareil d'irradiation selon la revendication 10, caractérisé en ce que le dispositif (27, 28) permettant de rendre inactive la commande (19) de déplacement du circuit (37) et du détecteur de rayonnement (78) quand la source (24) émet un rayonnement est constitué d'une roue (27) solidaire de la source (24) et apte à s'engrener sur un pignon (28) qui assure la rotation d'une vis sans fin (73) qui déplace le plateau ascensionnel (70) supportant le circuit électronique (37) et le détecteur (78).

12. Appareil d'irradiation selon l'une quelconque des revendications 1 à 6 et 10 à 11, caractérisé en ce qu'il comprend un moyen composé de deux roues dentées (40, 77) qui sont en contact et permettent ainsi la rotation du circuit (37) uniquement quand le plateau ascensionnel (70) support de celui-ci est en position basse.

## Claims

1. Irradiation apparatus for electronic circuits, comprising an evacuated irradiation-tight enclosure (1) which can be demounted into at least two portions, a means (7) for setting up the vacuum in the enclosure, a movable carriage (23) bearing a radioactive source (24), an ascensional plate (70) for positioning the electronic circuit (37) to be tested, a radiation detector (78) and controls (19, 20) for moving the electronic circuit (37) and the detector (78), such controls being connected to one of the portions (2) of the evacuated enclosure (1) and manipulated from outside the enclosure (1), characterized in that it also comprises a source (24) moving control which is connected to one of the portions (2) of the evacuated enclosure (1) and manipulated from outside such enclosure (1) so as to move the source (24) successively into a first non-irradiating position, a second detector (28) irradiating position and a third electronic circuit (37) irradiating position, a means (24, 30, 101, 102, 103) being provided for identifying the presence of the source (24) in each of the three positions.

2. Irradiation apparatus according to claim 1, characterized in that it comprises a radioactive source (24) which disintegrates by spontaneous fission.

3. Irradiation apparatus according to claim 2, characterized in that its radioactive source (24) is composed of californium[252].

4. Irradiation apparatus according to any one of the claims 1 to 3, characterized in that it comprises a cover (64) connected to the evacuated enclosure (1) which prevents the source (24) from emitting a radiation for a certain position of such source (24).

5. Irradiation apparatus according to any one of the claims 1 to 4, characterized in that it comprises a mechanical blocking means (50) which prevents radiation when the enclosure (1) is not assembled.

6. Irradiation apparatus according to any one of the claims 1 to 5, characterized in that it comprises a means (50) preventing the enclosure (1) from being demounted when the source (24) emits a radiation.

7. Irradiation-simulating apparatus according to claims 5 or 6, characterized in that it comprises a movable electromagnet (60) having two bolts (58, 59) pointing in opposite directions and adapted to block the enclosure (1) in the assembled position and a device (51, 53, 55) for retaining the control (19) of the source (24) in the non-irradiating position respectively.

8. Irradiation apparatus according to claim 7, characterized in that the device (51, 53, 55) comprises a link (51) which is attached via one end to the base (2) of the apparatus and has a rod (53) adapted to receive the bolt (59) at the other end of such link, the articulation (55) between the link (51) and the rod (53) being used as a means for blocking such control (19).

9. Irradiation apparatus according to claim 1, characterized in that it comprises a means (81) for closing the radiation detector (78) when the source (24) is not positioned so as to irradiate the detector correctly.

10. Irradiation apparatus according to any one of the claims 1 to 8, characterized in that it comprises a device (27, 28) enabling the control (19) of the translation movement of the circuit (37) and the radiation detector (78) to be inactivated when the source (24) emits a radiation.

11. Irradiation apparatus according to claim 10, characterized in that the device (27, 28) enabling the control (19) of the movement of the circuit (37) and of the radiation detector (78) to be inactivated when the source (24) emits a radiation is formed by a wheel (27) connected to the source (24) and adapted to mesh with a pinion (28) rotating an endless screw (73) which moves the ascensional plate (70) supporting the electronic circuit (37) and the detector (78).

12. Irradiation apparatus according to any one of the claims 1 to 6 and 10 and 11, characterized in that it comprises a means made up of two toothed wheels (40, 77) which are in contact and thus enable the circuit (37) to be rotated only when the ascensional plate (70) supporting the circuit is in the bottom position.

**Patentansprüche**

1. Gerät zum Bestrahlen von elektronischen Schaltungen mit einer Vakuumglocke (1), die in wenigstens zwei Teile zerlegbar ist und strahlungsdicht ist, einer Vorrichtung (7) zum Erzeugen des Vakuums im Innern dieser Glocke (1); einem beweglichen Wagen (23), der eine radioaktive Quelle (24) trägt; und einem ansteigenden Plateau (70), um den zu testenden elektronischen Schaltkreis (37) in Position zu bringen, welches außerdem mit einem Strahlungsdetektor (78) versehen ist und Steuerungen (19, 20) zum Bewegen des elektronischen Schaltkreises (37) und des Detektors (78) umfaßt, die mit einem der Teile (2) der Vakuumglocke (1) verbunden sind und von außerhalb der Glocke (1) betätigt werden, dadurch gekennzeichnet, daß es außerdem eine Steuerung für die Bewegung der Quelle (24) umfaßt, die mit einem der Teile (2) der Vakuumglocke (1) verbunden sind und von außerhalb der Glocke (1) derart betätigt wird, daß die Quelle (24) Schritt für Schritt in eine erste, nicht strahlende, in eine zweite, den Detektor (78) bestrahlende und eine dritte, den elektronischen Schaltkreis bestrahlende Stellung gebracht wird, ebenso wie es eine Vorrichtung (29, 30, 101, 102, 103) zum Registrieren der Anwesenheit der Quelle in jeder der drei Stellungen umfaßt.

2. Gerät zum Bestrahlen nach Anspruch 1, dadurch gekennzeichnet, daß es eine radioaktive Quelle (24) umfaßt, die sich durch spontane Kernspaltung zerlegt.

3. Gerät zum Bestrahlen nach Anspruch 2, dadurch gekennzeichnet, daß die radioaktive Quelle (24) aus Californium 252 besteht.

4. Gerät zum Bestrahlen nach einem der Ansprüche 1 bis 3, dadurch gekennzeichnet, daß es einen Deckel (64) umfaßt, der mit der Vakuumglocke (1) verbunden ist und verhindert, daß die Quelle (24) eine Strahlung in einer bestimmten Position dieser Quelle (24) emittiert.

5. Gerät zum Bestrahlen nach einem der Ansprüche 1 bis 4, dadurch gekennzeichnet, daß es eine Vorrichtung (50) zum mechanischen Blokkieren umfaßt, die die Strahlung abschirmt, wenn die Glocke (1) nicht montiert ist.

6. Gerät zum Bestrahlen nach einem der Ansprüche 1 bis 5, dadurch gekennzeichnet, daß es eine Vorrichtung (50) umfaßt, die die Demontage der Glocke (1) verhindert, wenn die Quelle (24) eine Strahlung emittiert.

7. Gerät zum Bestrahlen nach den Ansprüchen 5 und 6, dadurch gekennzeichnet, daß es einen beweglichen Elektromagneten (60) mit zwei Bolzen (58, 59), die in entgegengesetzte Richtung zeigen und dazu bestimmt sind, jeweils die Glocke (1) in der montierten Stellung zu blockieren, und ein Vorrichtung (51, 52, 53) zum Halten der Steuerung (19) der Quelle (24) in einer nicht strahlenden Stellung umfaßt.

8. Gerät zum Bestrahlen nach Anspruch 7, dadurch gekennzeichnet, daß die Vorrichtung (51, 52, 53) ein Pleuel (51) umfaßt, das mit einem Ende am Sockel (2) des Geräts montiert ist und mit einer Stange (53) versehen ist, die geeignet ist, den Bolzen (59) an ihrem anderen Ende aufzunehmen, wobei das Gelenk (55) zwischen dem Pleuel (51) und dem Stab (53) als Vorrichtung zum Blockieren der Steuerung verwendet wird.

9. Gerät zum Bestrahlen nach Anspruch 1, dadurch gekennzeichnet, daß es eine Vorrichtung (81) zum Verschließen des Strahlungsdetektors (78) umfaßt, wenn die Quelle (24) nicht so angeordnet ist, daß sie diesen korrekt bestrahlt.

10. Gerät zum Bestrahlen nach einem der Ansprüche 1 bis 8, dadurch gekennzeichnet, daß es eine Vorrichtung (27, 28) umfaßt, die ermöglicht, die Steuerung (19) zur Translationsbewegung des Schaltkreises (37) und des Strahlungsdetektors (78) wirkungslos zu machen, wenn die Quelle (24) eine Strahlung emittiert.

11. Gerät zum Bestrahlen nach Anspruch 10, dadurch gekennzeichnet, daß die Vorrichtung (27, 28), die ermöglicht, die Steuerung (19) zur Translationsbewegung des Schaltkreises (37) und des Strahlungsdetektors (78) wirkungslos zu machen, wenn die Quelle (24) eine Strahlung emittiert, aus einem an der Quelle befestigten Rad (27) besteht, das geeignet ist, in ein Ritzel (28) zu greifen, das die Drehung einer Endlosschraube (73) sicherstellt, die das aufsteigende, den elektronischen Schaltkreis (37) und den Detektor (78) tragende Plateau (70) bewegt.

12. Gerät zum Bestrahlen nach einem der Ansprüche 1 bis 6 und 10 bis 11, dadurch gekennzeichnet, daß es eine Vorrichtung umfaßt, die aus zwei Zahnrädern (40, 77) besteht, in Berührung stehen und so die Drehung des Schaltkreises (37) nur dann erlauben, wenn das diesen tragende, aufsteigende Plateau (70) in der tiefen Stellung ist.

FIG. 1

FIG. 2

FIG. 3

FIG. 4

12

FIG. 5